# EUROPEAN PATENT SPECIFICATION

(11) **EP 0 424 600 B1**
(45) Date of publication and mention of the grant of the patent: **06.11.1996**
(21) Application number: 90107267.8
(22) Date of filing: 17.04.1990
(51) Int. Cl.: G01R 33/421

(54) **Magnet apparatus for use in a magnetic resonance imaging system**
Magnetgerät verwendet in einer magnetischen Resonanzabbildungsanordnung
Appareil magnétique pour système d'image de résonance magnétique

(30) Priority: 25.10.1989 JP 275956/89
(43) Date of publication of application: 02.05.1991
(73) Proprietor: KABUSHIKI KAISHA TOSHIBA, Kawasaki-shi, Kanagawa-ken 210 (JP)
(72) Inventor: Ohta, Tadatoshi, c/o Intellectual Property Div., Minato-ku, Tokyo 105 (JP)
(74) Representative: Henkel, Feiler, Hänzel & Partner

(56) References cited:
- EP-A- 0 187 691
- EP-A- 0 238 909
- EP-A- 0 334 382
- WO-A-90/10877
- GB-A- 2 070 254
- GB-A- 2 204 737
- GB-A- 2 215 471
- US-A- 4 490 675
- US-A- 4 595 899
- PATENT ABSTRACTS OF JAPAN vol. 12, no. 430 (E-682)(3277) 14 November 1988; & JP-A-63 166 203
- PATENT ABSTRACTS OF JAPAN vol. 13, no. 216 (E-760)(3564) 19 May 1989; & JP-A-6428805
- J. SCI. INSTRUM., vol. 42, 1965, pp. 766-767; E. MANTYSALO et al.: 'A superconducting magnet using double Helmholtz coils'

## Description

The present invention relates to a magnet apparatus for use in a magnetic resonance imaging system, and more particularly to a magnet apparatus having a magnetic shield.

A magnet apparatus in use in a magnetic resonance imaging system (hereinafter referred to as the "MRI system") has a bore for receiving an object to be examined or a patient. A working volume in which a to-be-diagnosed portion of the object is located is defined in the bore. A static magnetic field or a main magnetic field is generated in the working volume by a main coil. A gradient magnetic field is superposed on the static magnetic field, and a high frequency signal is applied to the to-be-diagnosed portion of the object so that a tomographic image of the to-be-diagnosed portion is obtained.

The magnetic fluxes of the magnetic field leak from the bore to form a leaked magnetic field outside of the bore. The leaked magnetic field sometimes causes an adverse effect on the atmosphere around the MRI system. In order to eliminate this effect, a magnet apparatus is provided with a magnetic shield for reducing the leaked magnetic field. The magnetic shield is an active magnetic shield or cancel coils, for example.

The cancel coils generate a second magnetic field, the magnetic fluxes of which are directed in the direction opposite to that of the magnetic fluxes of the static magnetic field. The leaked magnetic field and the second magnetic field have substantially the same intensities. Therefore, both the magnetic fields cancel each other to reduce the leaked magnetic field greatly.

In the conventional magnet apparatus, cancel coils coaxially surround the main coil. A first bobbin of the main coil and a second bobbin of the cancel coils coaxially surrounding the first coil are used in order to arrange both coil like this. Since both coils have complicated structures, it is difficult to assemble them together. The axis of the second bobbin is sometimes deviated from that of the first bobbin due to an assembly error between both the coils and/or due to an electromagnetic force produced when the coils are excited. This causes the cancel coils to make misalignment with the main coil, with the result that a uniform static magnetic field is not maintained in the working volume and the tomographic image is deteriorated. Further, since the cancel coils are arranged radially outside of the main coil, the outer diameter of the magnet apparatus is rendered relatively large, making it difficult to transport the magnet apparatus.

Prior art document US-A-4 595 899 discloses a method of opearting a magnet apparatus according to that of the precharacterizing part of claim 1. In this method, the bobbin which supports the active shield coils is arranged coaxially with the bobbin of the main field coils and is formed integral therewith. The main field coils are independently energized to establish a uniform field within these coils having suppressed lower order derivatives of flux with respect to positions within the uniform field.

Further, prior art document J. Sci. Instrum. 42 (1965), pages 766 and 767 describes a double Helmholtz arrangement wherein bobbins are formed integral with each other in order to maintain alignment between the field coils wound on the bobbins.

Finally, prior art document GB-A-2 215 471 discloses a superconducting magnet according to the preamble of Claim 3 in which an active shield comprises superconducting coils which coaxially surround the main coil.

It is an object of this invention to provide a magnet apparatus for use in a magnetic resonance imaging system, which has a simple structure and a relatively small outer diameter, which can be disposed close to a wall to use the space of a diagnosis room effectively or to allow a MRI system to be arranged in a relatively small diagnosis room, and in which a static magnetic field is distributed uniformly in the working volume defined in a bore.

To solve this object the present invention provides a method of operating a magnet apparatus according to claim 1 and a magnet apparatus as specified in claim 3.

The magnet apparatus used in the present invention has an active magnetic shield (or a cancel coil) coaxially disposed outside of a main coil at least one end.thereof. Therefore, it has a simpler structure and has two coils more easily assembled together than the conventional magnet apparatus. The magnet apparatus of the present invention has a small outer diameter, because it is unnecessary to increase its radius. The axes of the first bobbin of the main coil and the second bobbin of the cancel coil are rarely deviated from each other due to an assembly error and an magnetomotive force when both the coils are excited. As a result, the static magnetic field in the working volume defined in the bore is prevented from being distributed unevenly and the tomographic image is refrained from being deteriorated.

The present invention will be fully understood from the following detailed description with reference to the accompanying drawings in which:
Fig. 1 is a longitudinal sectional view of a magnet apparatus used in the first embodiment of the present invention;
Fig. 2 is a schematic view illustrating the operation of the magnet apparatus of Fig. 1;
Fig. 3 is a plan view of a diagnosis room in which an MRI system is arranged;
Fig. 4 is a longitudinal sectional view of a magnet apparatus which does not form an embodiment of the present invention;
Fig. 5 is a longitudinal sectional view of a magnet apparatus according to the second embodiment of the present invention; and
Figs. 6A and 6B are partially sectional views of magnet apparatuses, the views illustrating the leaked magnetic fields which are absorbed by a yoke magnetic shields.

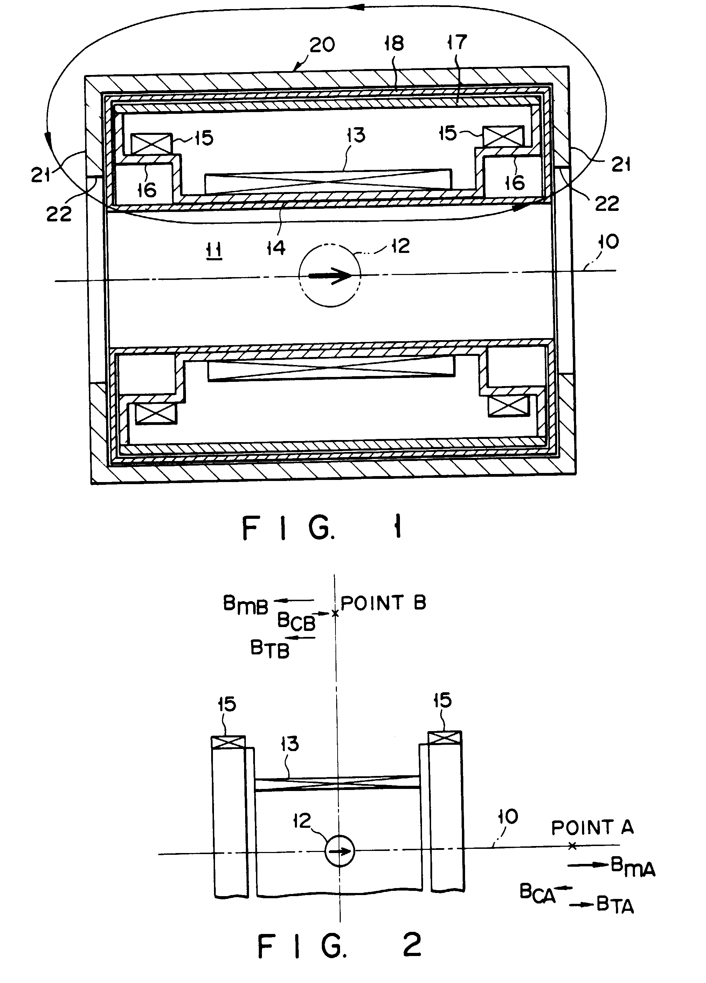

Fig. 1 shows a magnet apparatus for use in an MRI system according to the first embodiment of the present invention. The magnet apparatus has a bore 11 for receiving an object to be examined or a patient. A working volume 12 is defined in the bore 11. A main coil 13 having a first bobbin 14 surrounds the bore 11 so as to produce a static magnetic field in the working volume 12. The axis of the main coil 13 is denoted by 10.

A pair of cancel coils 15 are arranged coaxially with the axis 10 and outside the main coil 13 in the axial direction. Each cancel coil 15 has a larger outer diameter than the main coil 11. Thus, the second bobbin 16 of the cancel coil 15 has a larger outer diameter than the first bobbin 14 of the main coil 13. The bobbin 16 is formed integral with the bobbin 14. Bobbins 14 and 16 define the internal peripheral surface of a double cylindrical-shaped cryostat 17. The cryostat 17 is housed in a double cylindrical-shaped vacuum container 18.

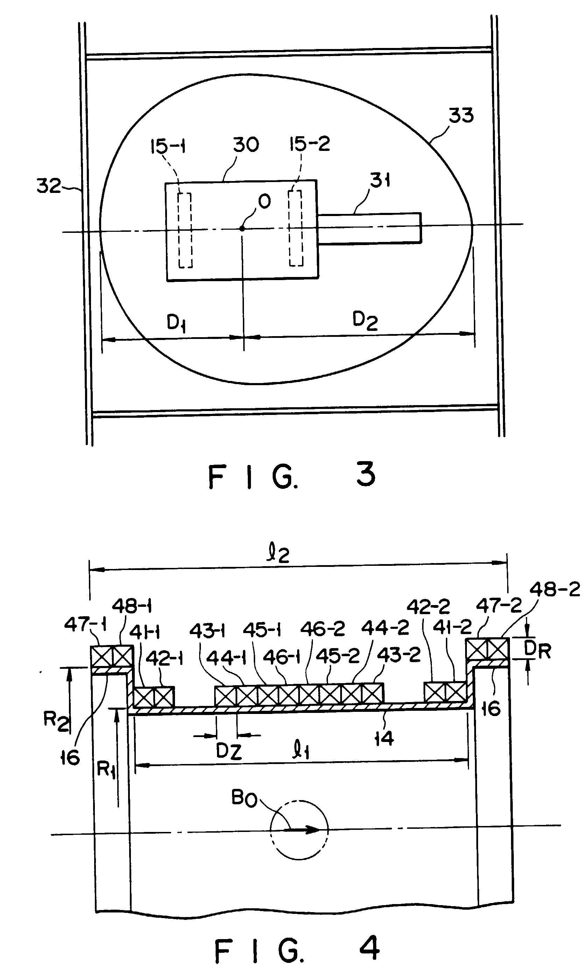

Referring to Fig. 2, the operation of the cancel coils 15 will now be explained.

A current is caused to flow in the cancel coils 15 in a direction opposite to that of the current flowing in the main coil 13, so that the cancel coils 15 produce a second magnetic field. The magnetic fluxes of the second field is directed in the direction opposite to that of the magnetic fluxes of the static magnetic field. For example, at a point A on the axis 10, a second magnetic field B_{CA} due to the cancel coils 15 and a static magnetic field B_{mA} (the leaked magnetic field) are superposed on each other. The second magnetic field B_{CA} cancels out most of the leaked magnetic field B_{CA} to reduce the intensity of the leaked magnetic field at the point A to a small value of B_{TA}. Likewise, the intensity of the leaked magnetic field is reduced at a point B disposed radially outside of the main coil 11.

In particular, the cancel coils 15 are disposed outside the main coil 11 in the axial direction and has a larger outer diameter than the main coil 11. The leaked fluxes leaking in parallel with the axis 10 from the bore 10 are reduced at an approximately same rate as in the conventional case. As shown by an looped arrow in Fig. 1, the leaked magnetic fluxes, which leak along the circumferential wall from one end of the bore 11 and reenter the bore at the other end, are reduced much more than in the conventional case.

In the working volume 12, the static magnetic field is also reduced by the second magnetic field. Since, however, the cancel coils 15 are much more separated from the working volume 12 than the main coil 13, the reduction rate of the static magnetic field in the working volume 12 is much less than that of the leaked magnetic field and therefore does not influence diagnosis.

The magnet apparatus is provided with a yoke magnetic shield 20 made of a ferromagnetic substance. The yoke magnetic shield 20 has a pair of annular flanges (annular members) 21 which are provided at the outer end sides of the respective cancel coils 15 and have annular inner edge portions defining a pair holes 22 for passing the object to be examined or the patient. The yoke magnetic shield 20 absorbs the leaked magnetic field through the annular inner edge portions of the flanges 21 to reduce the leaked magnetic field.

As seen from the above description, the cancel coil 15 drastically reduces the leaked magnetic field in cooperation with the magnetic shield 20.

In the first embodiment, the cancel coils 15 are arranged outside of the main coil 13 at its both ends, and the second bobbin 16 is formed integrally with the first coil frame 14. This structure makes the two coils simple in structure and assembled together very easily. Further, the magnet apparatus is reduced in outer diameter because it is unnecessary to increase its radius.

The integral structure of the two bobbin reduces an assembly error so as to prevent the misalignment of the axis of the second bobbin 16 with the axis of the first bobbin 14. Further, the axes of the first and second bobbins 14 and 16 are refrained from being misaligned, although magnetomotive forces are produced when the coils are excited. According to the feature in which the concentricity is maintained between the main coil and the cancel coils, the static magnetic field is prevented from being distributed unevenly and the tomographic image is also hindered from being deteriorated.

Fig. 3 is a plan view of a diagnosis room in which an MRI system 30 is arranged. Since a bed 31 is disposed at one side (the right side) of the MRI system 30, the system is arranged such that the other side (the left side) thereof is disposed near the wall 32 of the diagnosis room. In this arrangement, the leaked magnetic field leaking from the left side of the system sometimes influences the exterior of the wall 32.

In the first embodiment, the cancel coil 15-1 located at the left side of the system has a larger magnetomotive force than the cancel coil 15-2 located at the right side thereof. In this case, the leaked magnetic field leaking from the right side of the MRI system 30 is more reduced than that leaking from the left side of the system. Specifically, as is shown in

Fig. 3, the Gaussian curve 33 of the leaked magnetic field is asymmetric so that the right and left curve portions do not form an mirror image (that is, D₁ < D₂) such that the leaked magnetic field does not affect the exterior of the wall 32. Accordingly, the MRI system 30 can be disposed closer to the wall 32 to use the space of the diagnosis room effectively or to allow the MRI system to be arranged in a relatively small diagnosis room.

The use of the different magnetomotive forces of the two cancel coils may cause a magnetic field error in the working volume. However, this error can be eliminated by adjusting the main coil.

In the first embodiment, the MRI system has a pair of cancel coils. However, alternatively, a single cancel coil 15-1 may be provided on the left side of the MRI system 30. In this case, the intensity of the leaked magnetic field leaking from the left side of the MRI system is more reduced by that leaking from the right side of the MRI system, whereby the leaked magnetic field leaking from the MRI system 30 is greatly prevented from affecting the exterior of the wall 32.

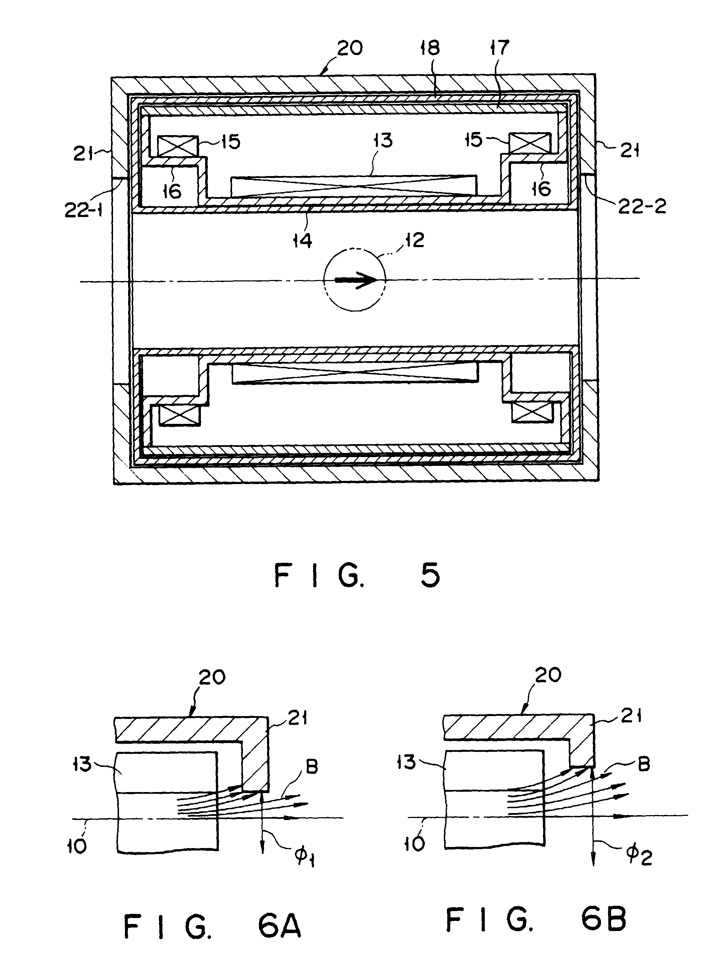

In Fig. 4, which does not show an embodiment of this invention the magnet apparatus of the first embodiment is further modified so as to be actually manufactured. The magnet apparatus comprises twelve main coils 41-1, 41-2, 42-1, 42-2, 43-1, 43-2, 44-1, 44-2, 45-1, 45-2, 46-1 and 46-2 made of superconducting coils, four cancel coils 47-1, 47-2, 48-1 and 48-2 also made of superconducting coils, and a first bobbin 14 and second bobbin 16 both having the same structure as those of the first embodiment.

When the magnetomotive forces as is shown in Table 1 are applied to the coils, the intensity of the central magnetic field in the working volume becomes 1.5T, and this intensity of the magnetic field is maintained throughout the working volume.

**Table 1**

| Coils | | | Magnetomotive Forces [AT] |
|---|---|---|---|
| DZ = 100 [mm] | 41-1 | 41-2 | 1844710 |
| DR = 30 [mm] | 42-1 | 42-1 | 59065 |
| | 43-1 | 43-2 | 419548 |
| R₁ = 600 [mm] | 44-1 | 44-2 | 39125 |
| R₂ = 800 [mm] | 45-2 | 45-2 | 195385 |
| | 46-1 | 46-2 | 145482 |
| l₁ = 1600 [mm] | 47-1 | 47-2 | -334940 |
| l₂ = 2000 [mm] | 48-1 | 48-2 | -1260510 |

Table 2 shows the relationship between the intensities of the magnetic fields at the center of the working volume, at an axial position 6m away from the center and at a radial position 4m away from the center. In this table are shown the intensities of the magnetic fields produced by each coil at the indicated positions.

**Table 2**

| | Center | Axial Position 6[ m] | Radial Position 4[ m] |
|---|---|---|---|
| Main Coil | 2.288 [T] | 0.00627[T] (62.7[G]) | 0.00913 [T] (91.3 [G]) |
| Cancel Coils | -0.788 | -0.00574 [T] (-57.4 [G]) | -0.00864 [T] (-86.4 [G]) |
| Total | 1.500 | 5.3 | 4.9 |

Since a pair of cancel coils are arranged outside the main coil in the axial direction, the leaked magnetic field is greatly reduced. As compared with the conventional case, it is very easy to assembly the two kinds of coils together and an accurate concentricity of the second bobbin 16 with the first bobbin 14 is ensured. Accordingly, the static magnetic field in the working volume defined in the bore is prevented from being distributed unevenly and the tomographic image does not become deteriorated.

The second embodiment of the present invention will now be explained with reference to Figs. 5, 6A and 6B.

In an MRI system according to the second embodiment, a hole 22-1 in the left end wall of a yoke shield 20 has a smaller diameter than a hole 22-2 in the right end wall thereof.

On one hand, when the diameter φ₁ of the hole in the end wall of the shield is small, as is shown in Fig. 6A, a large amount of the leaked magnetic field B is absorbed by the annular inner portion of the flange 21 of the shield. On the other hand, when the diameter φ₂ of the hole in the end wall of the shield is large, as is shown in Fig. 6B, a small amount of the magnetic field B is absorbed by the annular inner portion of the flange of the shield.

According to the MRI system of the second embodiment, the hole in the end of the shield at the right side of the MRI system (that is, the hole closer to the wall 32) is rendered smaller than the hole in the end of the shield at the left side of the system (i.e., the hole closer to the bed) in the diagnosis room, as is shown in Fig. 3. The leaked magnetic field leaking from the MRI system at its left side is much more reduced than that at its right side. Accordingly, the leaked magnetic field leaking from the MRI system is prevented from affecting the exterior of the wall 32. This arrangement enables the MRI system 30 to be disposed closer to the wall 32 and thus allows the diagnosis room to be utilized effectively. Further, the MRI system can be provided in a relatively small diagnosis room.

In the above embodiments, the main coils and the cancel coils may be superconducting coils or normally conducting coils. Further, they may be of solenoid type or of Helmholtz type instead.

## Claims

1. A method of operating a magnet apparatus for use in a magnetic resonance imaging system having a bore (11) for housing an object to be examined and an axis (10) passing through the bore (11), said method comprising:
using a main coil (13) for producing a main magnetic field along the axis (10) in the bore (11), so that the magnetic fluxes leak from the bore (11), said main coil (13) having a symmetry plane orthogonal to said axis and being disposed on a first bobbin (14) coaxially surrounding the bore (11); and
using active magnetic shield means (15) for producing a second magnetic field in a direction opposite to the leaked magnetic field so that the second magnetic field cancels out most part of the leaked magnetic field to reduce the leakage magnetic fluxes, said active magnetic shield means (15) being disposed on second bobbins (16) arranged coaxially with the first bobbin (14) at both ends thereof and formed integral therewith, wherein:
said active magnetic shield means (15) includes a pair of cancel coils (15) arranged symmetrically with respect to said symmetry plane of said main coil (13) for producing the second magnetic field, the second bobbins (16) of said cancel coils (15) being arranged coaxially with the first bobbin (14) at both ends thereof and formed integral therewith,
said method being characterized in that it comprises causing one of said cancel coils to (15) generate a larger magnetomotive force than the other cancel coil (15), or even entirely omitting one of said cancel coils.

2. A method according to claim 1, characterized in that said magnet apparatus further comprises yoke magnetic shield means (20), coaxially surrounding the main coil (13) and including a pair of annular members (21) defining a pair of circular holes (22) which are arranged outside said main coil (13) in the axial direction and are concentric with said axis, for absorbing part of the leaked magnetic fluxes through the annular members (21), whereby said cancel coils (15) and yoke shield means (20) cooperate with each other to reduce the leaked magnetic fluxes, and
in that said pair of cancel coils (15) are arranged outside of the main coil (13) in the axial direction, the diameter of said cancel coils (15) being larger than that of the main coil (13).

3. A magnet apparatus for use in a magnetic resonance imaging system having a bore (11) for housing an object to be examined, and an axis (10) passing through the bore (11), said magnet apparatus comprising:
a main coil (13), coaxially surrounding the bore (11), for producing a main magnetic field along the axis (10) in the bore (11), so that the magnetic fluxes leak from the bore (11); and
yoke magnetic shield means (20), coaxially surrounding the main coil (13) and including a pair of annular members (21) defining a pair of circular holes (22) which are arranged outside said main coil (13) in the axial direction and are concentric with said axis (10), for reducing the intensity of the leaked magnetic fluxes through the annular members (21),
characterized in that
the diameter of one of the circular holes (22) is larger than that of the other hole (22).

4. A magnet apparatus according to claim 3,
characterized by further comprising a pair of cancel coils (15), arranged coaxially with the bore (11) and outside said main coil (13) in the axial direction, for producing a second magnetic field in a direction opposite to the leaked magnetic field so that the second magnetic field cancels out most part of the leaked magnetic field, whereby said yoke shield means (20) and cancel coils (15) cooperate with each other to reduce the leaked magnetic fluxes.

5. A magnet apparatus according to claim 4,
characterized in that said main coil (13) has a first bobbin (14) and said pair of cancel coils (15) have second bobbins (16) arranged coaxially with the first bobbin at both ends thereof and formed integral therewith.

6. A magnet apparatus according to claim 3,
characterized by further comprising a pair of cancel coils (15), arranged coaxially with the bore (11), symmetrically with respect to the symmetry plane of the main coil (13) and arranged outside of the main coil (13) in the axial direction, for producing a second magnetic field in a direction opposite to the leaked magnetic field so that the second magnetic field reduces the intensity of the leaked magnetic field, the diameter of said cancel coils (15) being larger than that of the main coil (13), wherein:
said yoke magnetic shield means (20) absorbs part of the leaked magnetic fluxes through the annular members (21), whereby said cancel coils (15) and yoke shield means (20) cooperate with each other to reduce the leaked magnetic fluxes.

## Patentansprüche

1. Verfahren zum Betreiben eines Magnetgerätes zur Verwendung in einem Magnetresonanzabbildungssystem mit einer Bohrung (11) zum Aufnehmen eines zu untersuchenden Objektes und einer Achse (10), die durch die Bohrung (11) verläuft, wobei das Verfahren umfaßt:
Verwenden einer Hauptspule (13) zum Erzeugen eines Hauptmagnetfeldes längs der Achse (10) in der Bohrung (11), so daß die Magnetflüsse aus der Bohrung (11) austreten, wobei die Hauptspule (13) eine Symmetrieebene senkrecht zu der Achse hat und auf einer ersten Wicklung (14) angeordnet ist, die koaxial die Bohrung (11) umgibt, und
Verwenden einer aktiven Magnetabschirmungseinrichtung (15) zum Erzeugen eines Magnetfeldes in einer Richtung entgegengesetzt zu dem Leckmagnetfeld, so daß das zweite Magnetfeld den größten Teil des Leckmagnetfeldes löscht, um die Leckmagnetflüsse zu reduzieren, wobei die aktive Magnetabschirmungseinrichtung (15) auf zweiten Wicklungen (16) vorgesehen ist, die koaxial mit der ersten Wicklung (14) an beiden Enden hiervon angeordnet und hiermit integral ausgebildet sind, wobei:
die aktive Magnetabschirmungseinrichtung (15) ein Paar von Löschspulen (15) umfaßt, die symmetrisch bezüglich der Symmetrieebene der Hauptspule (13) angeordnet sind, um das zweite Magnetfeld zu erzeugen, wobei die zweiten Wicklungen (16) der Löschspulen (15) koaxial mit der ersten Wicklung (14) an beiden Enden hiervon angeordnet und integral hiermit ausgebildet sind,
wobei das Verfahren dadurch gekennzeichnet ist, daß es eine der Löschspulen (15) veranlaßt, eine größere magnetomotorische Kraft als die andere Löschspule (15) zu erzeugen oder sogar ganz eine der Löschspulen wegzulassen.

2. Verfahren nach Anspruch 1, dadurch gekennzeichnet, daß das Magnetgerät weiterhin eine Jochmagnetabschirmungseinrichtung (20) umfaßt, die koaxial die Hauptspule (13) umgibt und zwei ringförmige Glieder (21) umfaßt, die ein Paar von kreisförmigen Löchern (22) definieren, die außerhalb der Hauptspule (13) in der Axialrichtung angeordnet und konzentrisch mit der Achse sind, um einen Teil der Leckmagnetflüsse durch die ringförmigen Glieder (21) zu absorbieren, wodurch die Löschspulen (15) und die Jochabschirmungseinrichtung (20) zusammenarbeiten, um die Leckmagnetflüsse zu reduzieren, und
daß das Paar der Löschspulen (15) außerhalb der Hauptspule (13) in der Axialrichtung angeordnet ist, wobei der Durchmesser der Löschspulen (15) größer als derjenige der Hauptspule (13) ist.

3. Magnetgerät zur Verwendung in einem Magnetresonanzabbildungssystem mit einer Bohrung (11), um ein zu untersuchendes Objekt aufzunehmen, und einer Achse (10), die durch die Bohrung (11) verläuft, wobei das Magnetgerät aufweist:
eine Hauptspule (13), die koaxial die Bohrung (11) umgibt, um ein Hauptmagnetfeld längs der Achse (10) in der Bohrung (11) zu erzeugen, so daß die Magnetflüsse aus der Bohrung (11) austreten bzw. lecken, und
eine Jochmagnetabschirmungseinrichtung (20), die koaxial die Hauptspule (13) umgibt und ein Paar von ringförmigen Gliedern (21) umfaßt, die ein Paar von kreisförmigen Löchern (22) definieren, die außerhalb der Hauptspule (13) in der Axialrichtung angeordnet und konzentrisch zu der Achse (10) sind, um die Intensität der Leckmagnetflüsse durch die ringförmigen Glieder (21) zu reduzieren,
dadurch gekennzeichnet, daß
der Durchmesser von einem der kreisförmigen Löcher (22) größer als derjenige des anderen Loches (22) ist.

4. Magnetgerät nach Anspruch 3, gekennzeichnet durch weiterhin ein Paar von Löschspulen (15), die koaxial mit der Bohrung (11) und außerhalb der Hauptspule (13) in der Axialrichtung angeordnet sind, um ein zweites Magnetfeld in einer Richtung entgegengesetzt zu dem Leckmagnetfeld zu erzeugen, so daß das zweite Magnetfeld den größten Teil des Leckmagnetfeldes auslöscht, wodurch die Jochabschirmungseinrichtung (20) und Löschspulen (15) zusammenwirken, um die Leckmagnetflüsse zu reduzieren.

5. Magnetgerät nach Anspruch 4, dadurch gekennzeichnet, daß die Hauptspule (13) eine erste Wicklung (14) hat und das Paar von Löschspulen (15) zweite Wicklungen (16) aufweist, die koaxial mit der ersten Wicklung an beiden Enden hiervon ausgebildet und hiermit integral geformt sind.

6. Magnetgerät nach Anspruch 3, gekennzeichnet durch weiterhin ein Paar von Löschspulen (15), die koaxial mit der Bohrung (11) symmetrisch bezüglich der symmetrieebene der Hauptspule (13) und außerhalb der Hauptspule (13) in der Axialrichtung angeordnet sind, um ein zweites Magnetfeld in einer Richtung entgegengesetzt zu dem Leckmagnetfeld zu erzeugen, so daß das zweite Magnetfeld die Intensität des Leckmagnetfeldes reduziert, wobei der Durchmesser der Löschspulen (15) größer als derjenige der Hauptspule (13) ist, wobei:
die Jochmagnetabschirmungseinrichtung (20) einen Teil der Leckmagnetflüsse durch die ringförmigen Glieder (21) absorbiert, wodurch die Löschspulen (15) und die Jochabschirmungseinrichtung (20) zusammenwirken, um die Leckmagnetflüsse zu reduzieren.

## Revendications

1. Procédé pour faire fonctionner un dispositif formant aimant pour utilisation dans un système d'imagerie par résonance magnétique, ayant une ouverture (11) pour recevoir un objet à examiner et un axe (10) passant dans l'ouverture (11), ledit procédé comprenant les étapes consistant à:
- utiliser une bobine principale (13) pour produire un champ magnétique principal le long de l'axe (10) dans l'ouverture (11) de telle manière que les flux magnétiques fuient hors de l'ouverture (11), ladite bobine principale (13) ayant un plan de symétrie orthogonal audit axe et étant disposée sur une première carcasse de bobine (14) entourant coaxialement l'ouverture (11); et
- utiliser des moyens actifs de blindage magnétique (15) pour produire un deuxième champ magnétique dans une direction opposée au champ magnétique de fuite de telle manière que le deuxième champ magnétique annule la plus grande partie du champ magnétique de fuite pour réduire les flux magnétiques de fuite, lesdits moyens actifs de blindage magnétique (15) étant disposés sur des deuxièmes carcasses de bobines disposées coaxialement par rapport à la première carcasse de bobine (14), aux deux extrémités de celle-ci, et formées d'une seule pièce avec celle-ci, dans lequel:
lesdits moyens actifs de blindage magnétique (15) comprennent une paire de bobines d'annulation (15) disposées symétriquement par rapport audit plan de symétrie de ladite bobine principale (13) pour produire le deuxième champ magnétique, les deuxièmes carcasses de bobines (16) desdites bobines d'annulation (15) étant disposées coaxialement par rapport à la première carcasse de bobine (14), aux deux extrémités de celle-ci, et formées d'une seule pièce avec celle-ci,
ledit procédé étant caractérisé en ce qu'il comprend l'étape consistant à amener une desdites bobines d'annulation (15) à produire une force magnétomotrice plus grande que celle de l'autre bobine d'annulation (15) ou même à omettre entièrement une desdites bobines d'annulation.

2. Procédé selon la revendication 1, caractérisé en ce que ledit dispositif formant aimant comprend en outre des moyens de blindage magnétique de culasse (20) entourant coaxialement la bobine principale (13) et comprenant une paire d'organes annulaires (21) définissant une paire de trous circulaires (22) qui sont disposés à l'extérieur de la dite bobine principale (13) dans la direction axiale et sont concentriques audit axe, pour absorber une partie des flux magnétiques de fuite par les organes annulaires (21), ce par quoi lesdites bobines d'annulation (15) et lesdits moyens de blindage de culasse (20) coopèrent les uns avec les autres pour réduire les flux magnétiques de fuite; et
en ce que les bobines de ladite paire de bobines d'annulation (15) sont disposées à l'extérieur de la bobine principale (13) dans la direction axiale, le diamètre desdites bobines d'annulation (15) étant plus grand que celui de la bobine principale (13).

3. Dispositif formant aimant pour utilisation dans un système d'imagerie par résonance magnétique ayant une ouverture (11) pour recevoir un objet à examiner, et un axe (10) passant dans l'ouverture (11), ledit dispositif formant aimant comprenant:
- une bobine principale (13) entourant coaxialement l'ouverture (11) pour produire un champ magnétique principal le long de l'axe (10) dans l'ouverture (11) de telle manière que les flux magnétiques fuient hors de l'ouverture (11); et
- des moyens de blindage magnétique de culasse (20) entourant coaxialement la bobine principale (13) et comprenant une paire d'organes annulaires (21) définissant une paire de trous circulaires (22) qui sont disposés à l'extérieur de ladite bobine principale (13) dans la direction axiale et sont concentriques audit axe (10), pour réduire l'intensité des flux magnétiques de fuite par les organes annulaires (21).
caractérisé en ce que:
- le diamètre d'un des trous circulaires (22) est plus grand que celui de l'autre trou (22).

4. Dispositif formant aimant selon la revendication 3,
caractérisé en ce qu'il comprend en outre une paire de bobines d'annulation (15) disposées coaxialement par rapport à l'ouverture (11) et à l'extérieur de ladite bobine principale (13) dans la direction axiale, pour produire un deuxième champ magnétique dans une direction opposée au champ magnétique de fuite, de telle manière que le deuxième champ magnétique annule la plus grande partie du champ magnétique de fuite, ce par quoi lesdits moyens de blindage de culasse (20) et les bobines d'annulation (15) coopèrent les uns avec les autres pour réduire les flux magnétiques de suite.

5. Dispositif formant aimant selon la revendication 4, caractérisé en ce que ladite bobine principale (13) a une première carcasse de bobine (14) et ladite paire de bobines d'annulation (15) a des deuxièmes carcasses de bobines (16) disposées coaxialement par rapport à la première carcasse de bobine, aux deux extrémités de celle-ci, et formées d'une seule pièce avec celle-ci.

6. Dispositif formant aimant selon la revendication 3, caractérisé en ce qu'il comprend en outre une paire de bobines d'annulation (15) disposées coaxialement par rapport à l'ouverture (11), symétriquement par rapport au plan de symétrie de la bobine principale (13), et disposées à l'extérieur de la bobine prncipale (13) dans la direction axiale, pour produire un deuxième champ magnétique dans une direction opposée au champ magnétique de fuite, de telle manière que le deuxième champ magnétique réduise l'intensité du champ magnétique de fuite, le diamètre desdites bobines d'annulation (15) étant plus grand que celui de la bobine principale (13), dans lequel:
- lesdits moyens de blindage magnétique de culasse (20) absorbent une partie des flux magnétiques de fuite par les organes annulaires (21), ce par quoi lesdites bobines d'annulation (15) et lesdits moyens de blindage de culasse (20) coopèrent les uns avec les autres pour réduire les flux magnétiques de fuite.
